# EUROPEAN PATENT SPECIFICATION

(11) **EP 3 817 521 B1**
(45) Date of publication and mention of the grant of the patent: **04.03.2026**
(21) Application number: 19912090.8
(22) Date of filing: 07.11.2019
(51) Int. Cl.: H05K 1/11

(54) **PRINTED CIRCUIT BOARD, POWER SUPPLY, AND POWER SUPPLY SYSTEM**
LEITERPLATTE, STROMVERSORGUNG UND STROMVERSORGUNGSSYSTEM
CARTE DE CIRCUIT IMPRIMÉ, ALIMENTATION ÉLECTRIQUE ET SYSTÈME D'ALIMENTATION ÉLECTRIQUE

(30) Priority: 23.01.2019 CN 201920121024 U
(43) Date of publication of application: 05.05.2021
(73) Proprietor: HUAWEI TECHNOLOGIES CO., LTD., Shenzhen, Guangdong 518129 (CN)
(72) Inventor: CHEN, Zongxun, Shenzhen, Guangdong 518129 (CN); CHEN, Zuyu, Shenzhen, Guangdong 518129 (CN); ZHU, Qingfeng, Shenzhen, Guangdong 518129 (CN)
(74) Representative: Epping - Hermann - Fischer
(86) International application number: PCT/CN2019/116393
(87) International publication number: WO 2020/151304

(56) References cited:
- CN-A- 102 548 205
- CN-U- 201 957 339
- CN-U- 204 335 143
- CN-U- 206 371 005
- CN-U- 207 678 070
- JP-A- 2014 229 835
- US-A1- 2006 249 478
- US-A1- 2014 131 085

## Description

### TECHNICAL FIELD

This application relates to the field of electronic communications technologies, and in particular, to a printed circuit board, a power supply, and a power supply system.

### BACKGROUND

A printed circuit board (printed circuit board, PCB) usually includes a gold finger area and a soldering area. Electronic parts and components may be soldered to the soldering area, and a gold finger (gold finger) may be disposed in the gold finger area. The gold finger is formed by arranging a plurality of conductive contact sheets, and an outer surface of each conductive contact sheet may be gold-plated. The gold finger may be inserted into a slot of a female socket connector to implement signal transfer or energy transfer between the PCB board and the female socket connector.

In a related technology, resistance of the PCB board is usually reduced by increasing a thickness and an area of a copper foil on the PCB board, so as to reduce resistance of the gold finger area, and improve the through-current capability of the gold finger area

However, after the thickness and the area of the copper foil are increased, the copper foil absorbs a large amount of heat when a component is soldered to a soldering area on the PCB board. Consequently, this causes a relatively low soldering temperature and a poor soldering effect of the electronic parts and components.

US 2014/131085 A1 relates to a circuit board having a tie bar buried therein. The circuit board comprises a dielectric stack, comprising a first dielectric layer and a second dielectric layer, wherein the first dielectric layer is located on the second dielectric layer, the dielectric stack including a wireline region and a gold finger region; at least a first tie bar, buried in the gold finger region between the first dielectric layer and the second dielectric layer; at least a first gold finger, located in the gold finger region on the first dielectric layer on the first tie bar; and at least a first microvia, located in the gold finger region in the first dielectric layer and electrically connecting the first gold finger to the first tie bar.

### SUMMARY

The invention is set out in the appended claims.

This application provides a printed circuit board, a power supply, and a power supply system, to resolve a related-technology problem of a relatively low soldering temperature and a poor soldering effect of the electronic parts and components.

According to an aspect, a printed circuit board is provided. The printed circuit board may include a first outer conducting layer, a second outer conducting layer, and at least one insulation medium layer sandwiched between the first outer conducting layer and the second outer conducting layer; and the printed circuit board may include a gold finger area and a soldering area, where a total thickness of all conducting layers in the gold finger area may be greater than a total thickness of all conducting layers in the soldering area.

The total thickness of all conducting layers in the gold finger area is set to be relatively thick, so that resistance of the gold finger area can be reduced, and a through-current capability of the gold finger area is improved. In addition, the total thickness of all conducting layers in the soldering area is set to be relatively thin, so that a sufficient soldering temperature and a good soldering effect can be ensured when electronic parts and components are soldered to the soldering area.

On the printed circuit board, a total thickness of the gold finger area is equal to a total thickness of the soldering area. That is, an overall thickness of the printed circuit board may be consistent. In this way, smoothness of a surface of the printed circuit board can be ensured, so that smoothness of a gold finger disposed on the printed circuit board can be ensured, to ensure that the gold finger can be inserted into a female socket connector, thereby implementing an insertion and extraction function.

Optionally, there may be at least one target outer conducting layer in the first outer conducting layer and the second outer conducting layer, where a thickness of a part, of the gold finger area, in which the target outer conducting layer is located may be greater than a thickness of a part, of the soldering area, in which the target outer conducting layer is located. The thickness of the part, of the gold finger area, in which the target outer conducting layer is located is set to be relatively thick, so that the resistance of the gold finger area on the printed circuit board can be reduced, and the through-current capability of the gold finger area is improved.

Optionally, the thickness of the part, of the gold finger area, in which the target outer conducting layer is located may range from 4 oz to 20 oz (0,1388 mm to 0,694 mm); and the thickness of the part, of the soldering area, in which the target outer conducting layer located may range from 1/3 oz to 3 oz (0,0115666666666667 mm to 0,1041 mm). For example, the thickness of the part, of the gold finger area, in which the target outer conducting layer is located may be 10 oz (0,347 mm); and the thickness of the part, of the soldering area, in which the target outer conducting layer is located may be 2 oz (0,0694 mm).

Optionally, the printed circuit board may further include N inner conducting layers sandwiched between the first outer conducting layer and the second outer conducting layer, where N may be a positive integer greater than or equal to 1; one insulation medium layer is sandwiched between each outer conducting layer and an adjacent inner conducting layer; and one insulation medium layer is sandwiched between two adjacent inner conducting layers. That is, a total quantity of insulation medium layers that are disposed on the printed circuit board may be N + 1.

Optionally, there may be at least one target inner conducting layer in the N inner conducting layers, where a thickness of a part, of the gold finger area, in which the target inner conducting layer is located may be greater than a thickness of a part, of the soldering area, in which the target inner conducting layer is located. The thickness of the part, of the gold finger area, in which the target inner conducting layer is located is set to be relatively thick, so that the resistance of the gold finger area on the printed circuit board may be further reduced, and the through-current capability of the gold finger area is improved.

Optionally, the thickness of the part, of the gold finger area, in which the target inner conducting layer is located may range from 4 oz to 20 oz (0,1388 mm to 0,694 mm); and the thickness of the part, of the soldering area, in which the target inner conducting layer located may range from 1/3 oz to 3 oz (0,0115666666666667 mm to 0,1041 mm). For example, the thickness of the part, of the gold finger area, in which the target inner conducting layer is located may be 10 oz (0,347 mm), and the thickness of the part, of the soldering area, in which the target inner conducting layer is located may be 2 oz (0,0694 mm).

Optionally, N may be an even number. That is, the printed circuit board may include an even-numbered quantity of inner layers. The even-numbered quantity of inner conducting layers are disposed on the printed circuit board, so that symmetry of the printed circuit board can be ensured. In addition, the printed circuit board with the even-numbered quantity of inner layers does not require an additional core structure process and a foil coating process, so that processing costs are relatively low.

Optionally, at least one via of a blind via hole and a buried via hole may be disposed in the gold finger area, where the blind via hole may penetrate one outer conducting layer and at least one inner conducting layer; and the buried via hole may penetrate at least two inner conducting layers. At least one via of the blind via hole and the buried via hole is disposed, so that a heat dissipation capability of the printed circuit board can be improved. Therefore, this reduces a temperature of the gold finger area, reduces the resistance of the gold finger area, and improves the through-current capability of the gold finger area.

Optionally, a conducting material layer may be disposed on a side wall of the via. The conducting material layer is disposed on the side wall of the via, so that the resistance of the gold finger area may be further reduced, and the through-current capability of the gold finger area is improved.

Optionally, a plating through hole may be further disposed in the gold finger area, where the plating through hole may penetrate the first outer conducting layer and the second outer conducting layer. The plating through hole is disposed in the gold finger area, so that the heat dissipation capability of the printed circuit board can be improved. Therefore, this reduces the temperature of the gold finger area, reduces the resistance of the gold finger area, and improves the through-current capability of the gold finger area.

Optionally, a conducting material layer may be disposed on a side wall of the plating through hole. The conducting material layer is disposed on the side wall of the via, so that the resistance of the gold finger area may be further reduced, and the through-current capability of the gold finger area is improved.

Optionally, the printed circuit board may further include M inner-layer conducting blocks that are disposed in the gold finger area and sandwiched between the first outer conducting layer and the second outer conducting layer, where M is a positive integer greater than or equal to 1; and at least one of the M inner-layer conducting blocks is electrically connected to one inner conducting layer. The inner-layer conducting block is connected to one inner conducting layer, so that the through-current capability of the gold finger area can be further improved.

Optionally, the printed circuit board may further include at least one outer-layer conducting block of a first outer-layer conducting block and a second outer-layer conducting block that are disposed in the gold finger area, where an end face of the first outer-layer conducting block is in contact with an end face of the first outer conducting layer, and a surface that is of the first outer-layer conducting block and that is far away from the second outer conducting layer is coplanar with a surface that is of the first outer conducting layer and that is far away from the second outer conducting layer; and an end face of the second outer-layer conducting block is in contact with an end face of the second outer conducting layer, and a surface that is of the second outer-layer conducting block and that is far away from the first outer conducting layer is coplanar with a surface that is of the second outer conducting layer and that is far away from the first outer conducting layer, where the end face is parallel to a thickness direction of the printed circuit board. The first outer-layer conducting block and the second outer-layer conducting block are conducting blocks located on the surface of the printed circuit board. The outer-layer conducting is disposed on the surface of the printed circuit board, so that the heat dissipation capability of the printed circuit board can be effectively improved, the resistance of the gold finger area on the printed circuit board is reduced, and the through-current capability of the gold finger area is improved.

Optionally, the printed circuit board may further include a conducting side wall, where the conducting side wall is connected to end faces of all conducting layers in the gold finger area, where the end face is parallel to the thickness direction of the printed circuit board. All the conducting layers in the gold finger area may be electrically connected by disposing the conducting side wall, so that the through-current capability of the gold finger area is further improved. According to another aspect, a power supply is provided. The power supply may include electronic parts and components and the printed circuit board in the foregoing aspect. The electronic parts and components are soldered to a soldering area on the printed circuit board.

According to still another aspect, a power supply system is provided. The power supply system may include the power supply in the foregoing aspect and a female socket connector. In the power supply, a gold finger on a printed circuit board may be inserted into the female socket connector. The female socket connector may be a power connector.

Beneficial effects brought by the technical solutions provided in this application may include at least the following.

This application provides the printed circuit board, the power supply, and the power supply system. On the printed circuit board, the total thickness of all conducting layers in the gold finger area is greater than the total thickness of all conducting layers in the soldering area. Because the total thickness of all conducting layers in the gold finger area is set to be relatively thick, the resistance of the gold finger area can be reduced, and the through-current capability of the gold finger area is improved. In addition, the total thickness of all conducting layers in the soldering area is set to be relatively thin, so that a sufficient soldering temperature and a good soldering effect can be ensured when electronic parts and components are soldered to the soldering area.

### BRIEF DESCRIPTION OF DRAWINGS

FIG. 1 is a schematic structural diagram of a PCB board according to an embodiment of this application;
FIG. 2 is a schematic structural diagram of another PCB board according to an embodiment of this application;
FIG. 3 is a schematic structural diagram of still another PCB board according to an embodiment of this application;
FIG. 4 is a schematic structural diagram of yet another PCB board according to an embodiment of this application;
FIG. 5 is a schematic structural diagram of yet another PCB board according to an embodiment of this application;
FIG. 6 is a schematic structural diagram of yet another PCB board according to an embodiment of this application;
FIG. 7 is a schematic structural diagram of yet another PCB board according to an embodiment of this application;
FIG. 8 is a schematic structural diagram of yet another PCB board according to an embodiment of this application;
FIG. 9 is a schematic structural diagram of yet another PCB board according to an embodiment of this application;
FIG. 10 is a schematic structural diagram of yet another PCB board according to an embodiment of this application;
FIG. 11 is a schematic structural diagram of yet another PCB board according to an embodiment of this application;
FIG. 12 is a schematic structural diagram of yet another PCB board according to an embodiment of this application;
FIG. 13 is a schematic structural diagram of yet another PCB board according to an embodiment of this application;
FIG. 14 is a schematic structural diagram of yet another PCB board according to an embodiment of this application;
FIG. 15 is a schematic structural diagram of yet another PCB board according to an embodiment of this application;
FIG. 16 is a schematic structural diagram of yet another PCB board according to an embodiment of this application;
FIG. 17 is a schematic structural diagram of yet another PCB board according to an embodiment of this application;
FIG. 18 is a schematic structural diagram of yet another PCB board according to an embodiment of this application;
FIG. 19 is a schematic structural diagram of yet another PCB board according to an embodiment of this application;
FIG. 20 is a schematic structural diagram of yet another PCB board according to an embodiment of this application;
FIG. 21 is a schematic structural diagram of yet another PCB board according to an embodiment of this application;
FIG. 22 is a schematic structural diagram of yet another PCB board according to an embodiment of this application;
FIG. 23 is a schematic structural diagram of yet another PCB board according to an embodiment of this application;
FIG. 24 is a schematic structural diagram of yet another PCB board according to an embodiment of this application;
FIG. 25 is a schematic structural diagram of yet another PCB board according to an embodiment of this application;
FIG. 26 is a schematic structural diagram of yet another PCB board according to an embodiment of this application; and
FIG. 27 is a schematic structural diagram of yet another PCB board according to an embodiment of this application.

### DESCRIPTION OF EMBODIMENTS

To make objectives, technical solutions, and advantages of this application clearer, the following further describes implementations of this application in detail with reference to the accompanying drawings.

A printed circuit board (printed circuit board, PCB) usually includes a gold finger area and a soldering area. A gold finger may be disposed in the gold finger area, and the gold finger may be inserted into a slot of a female socket connector, to implement signal transfer or energy transfer between the gold finger area and the female socket connector. The gold finger area is a medium and a critical path for through current between a power supply and a load. Electronic parts and components may be soldered to the soldering area. The electronic parts and components may be soldered to the soldering area on the PCB board through reflow soldering or wave soldering, and the electronic parts and components may be connected to a conducting layer by using layout of the PCB board.

In a related technology, to improve a through-current capability of a gold finger area, a conducting layer on a PCB board is usually set to be relatively thick. However, the relatively thick conducting layer absorbs a large amount of heat, and consequently a soldering temperature is not high enough, and a soldering effect is relatively poor when electronic parts and components are soldered to a soldering area on the PCB board. Therefore, in consideration of the soldering effect, a thickness of the conducting layer on the PCB board cannot be set to be excessively thick. Otherwise, a contradiction that the soldering effect is poor although the through-current capability is improved may occur.

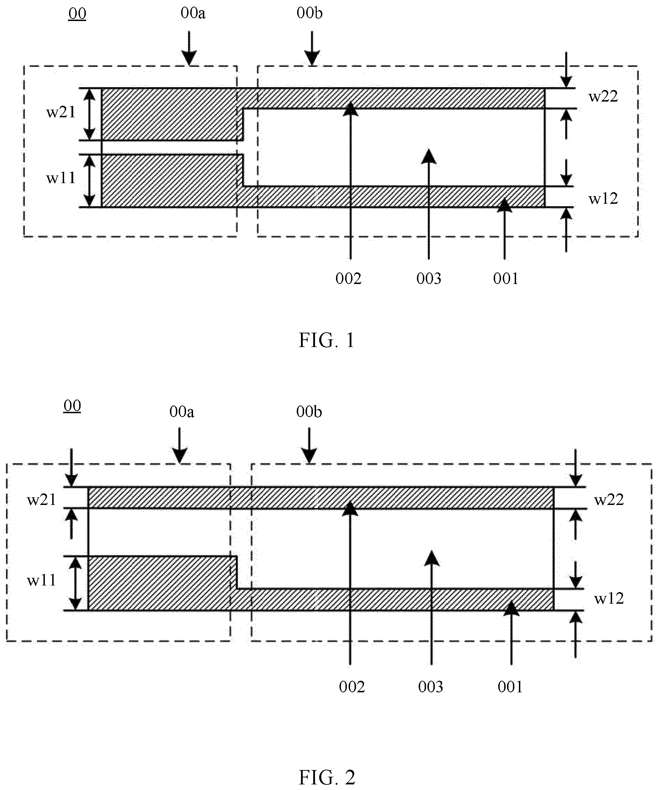

To resolve the related-technology problem that the soldering effect is relatively poor when a copper foil on the PCB board is relatively thick, an embodiment of this application provides a PCB board. Referring to FIG. 1, the PCB board 00 may include a first outer conducting layer 001, a second outer conducting layer 002, and at least one insulation medium layer 003 sandwiched between the first outer conducting layer 001 and the second outer conducting layer 002. For example, FIG. 1 shows only one insulation medium layer 003.

In this embodiment of this application, the PCB board 00 may include a gold finger area 00a and a soldering area 00b. A gold finger (not shown in FIG. 1) may be disposed in the gold finger area 00a. The gold finger may be formed by arranging a plurality of conductive contact sheets, and an outer surface of each conductive contact sheet may be gold-plated. In addition, a total thickness of all conducting layers in the gold finger area 00a is greater than a total thickness of all conducting layers in the soldering area 00b.

For example, on the PCB board 00 shown in FIG. 1, the conducting layers on the PCB board 00 may include the first outer conducting layer 001 and the second outer conducting layer 002. In this case, a total thickness W1 of the conducting layers in the gold finger area 00a may be equal to a sum of a thickness w11 of a part, of the gold finger area 00a, in which the first outer conducting layer 001 is located and a thickness w21 of a part, of the gold finger area 00a, in which the second outer conducting layer 002 is located, that is, W1 = w11 + w21. A total thickness W2 of the conducting layer in the soldering area 00b may be equal to a sum of a thickness w12 of a part, of the soldering area 00b, in which the first outer conducting layer 001 is located and a thickness w22 of a part, of the soldering area 00b, in which the second outer conducting layer 002 is located, that is, W2 = w12 + w22. Referring to FIG. 1, the sum W1 of the thickness of the first outer conducting layer 001 and the thickness of the second outer conducting layer 002 that are in the gold finger area 00a is greater than the sum W2 of the thickness of the first outer conducting layer 001 and the thickness of the second outer conducting layer 002 in the soldering area 00b, that is, W1 > W2.

In conclusion, this embodiment of this application provides the PCB board. On the PCB board, the total thickness of all conducting layers in the gold finger area is greater than the total thickness of all conducting layers in the soldering area. Because the total thickness of all conducting layers in the gold finger area is set to be relatively thick, resistance of the gold finger area can be reduced, and a through-current capability of the gold finger area is improved. In addition, the total thickness of all conducting layers in the soldering area is set to be relatively thin, so that a sufficient soldering temperature and a good soldering effect can be ensured when electronic parts and components are soldered to the soldering area.

Optionally, both the first outer conducting layer 001 and the second outer conducting layer 002 may be copper foils, and the insulation medium layer 003 may be an epoxy resin sheet.

Optionally, on the PCB board 00, a total thickness of the gold finger area 00a may be equal to a total thickness of the soldering area 00b. That is, an overall thickness of the PCB board 00 may be consistent. Referring to FIG. 1, on the PCB board 00, the part, of the gold finger area 00a, in which the first outer conducting layer 001 is located may protrude in a direction close to the second outer conducting layer 002, and the part, of the gold finger area 00a, in which the second outer conducting layer 002 is located may protrude in a direction close to the first outer conducting layer 001. In this way, smoothness of a surface of the PCB board 00 can be ensured, so that smoothness of a gold finger disposed on the PCB board 00 can be ensured, to ensure that the gold finger can be inserted into a female socket connector, thereby implementing an insertion and extraction function.

In this embodiment of this application, there may be at least one target outer conducting layer in the first outer conducting layer 001 and the second outer conducting layer 002, where a thickness of a part, of the gold finger area 00a, in which the target outer conducting layer is located may be greater than a thickness of a part, of the soldering area 00b, in which the target outer conducting layer is located. A thickness of a part, of the gold finger area 00a, in which an outer conducting layer other than the target outer conducting layer is located may be equal to a thickness of a part, of the soldering area 00b, in which the outer conducting layer is located, for example, may be equal to a thickness of a part, of the soldering area 00b, in which the target outer conducting layer is located.

For example, referring to FIG. 1, both the first outer conducting layer 001 and the second outer conducting layer 002 may be target outer conducting layers. The thickness w11 of the part, of the gold finger area 00a, in which the first outer conducting layer 001 is located is greater than the thickness w12 of the part, of the soldering area 00b, in which the first outer conducting layer 001 is located, that is, w11 > w12. The thickness w21 of the part, of the gold finger area 00a, in which the second outer conducting layer 002 is located is greater than the thickness w22 of the part, of the soldering area 00b, in which the second outer conducting layer 002 is located, that is, w21 > w22.

Alternatively, referring to FIG. 2, the first outer conducting layer 001 is the target conductive outer layer, and the second outer conducting layer 002 is not the target outer conducting layer. The thickness w11 of the part, of the gold finger area 00a, in which the first outer conducting layer 001 is located is greater than the thickness w12 of the part, of the soldering area 00b, in which the first outer conducting layer 001 is located, that is, w11 > w12. The thickness w21 of the part, of the gold finger area 00a, in which the second outer conducting layer 002 is located is equal to the thickness w22 of the part, of the soldering area 00b, in which the second outer conducting layer 002 is located, that is, w21 = w22.

Optionally, the thickness of the part, of the gold finger area 00a, in which the target outer conducting layer is located may range from 4 oz to 20 oz (0,1388 mm to 0,694 mm). The thickness of the part, of the soldering area 00b, in which the target outer conducting layer is located may range from 1/3 oz to 3 oz (0,0115666666666667 mm to 0,1041 mm). The thickness of the part, of the gold finger area 00a, in which an outer conducting layer other than the target outer conducting layer is located and the thickness of the part, of the soldering area 00b, in which the outer conducting layer is located may both range from 1/3 oz to 3 oz (0,0115666666666667 mm to 0,1041 mm).

For example, referring to FIG. 1, both the thickness of the part, of the gold finger area 00a, in which the first outer conducting layer 001 is located and the thickness of the part, of the gold finger area 00a, in which the second outer conducting layer 002 is located may be 10 oz (0,347 mm) (that is, w11 = w21 = 10 oz (0,347 mm)). Both the thickness of the part, of the soldering area 00b, in which the first outer conducting layer 001 is located and the thickness of the part, of the soldering area 00b, in which the second outer conducting layer 002 is located may be 2 oz (0,0694 mm) (that is, w12 = w22 = 2 oz (0,0694 mm)).

Alternatively, referring to FIG. 2, the thickness w11 of the part, of the gold finger area 00a, in which the first outer conducting layer 001 is located may be 10 oz (0,347 mm) (that is, w11 = 10 oz (0,347 mm)), and the thickness w12 of the part, of the soldering area 00b, in which the first outer conducting layer 001 is located may be 2 oz (0,0694 mm) (that is, w12 = 2 oz (0,0694 mm)). Both the thickness w21 of the part, of the gold finger area 00a, in which the second outer conducting layer 002 is located and the thickness w22 of the part, of the soldering area 00b, in which the second outer conducting layer 002 is located may be 2 oz (0,0694 mm) (that is, w21 = w22 = 2 oz (0,0694 mm)).

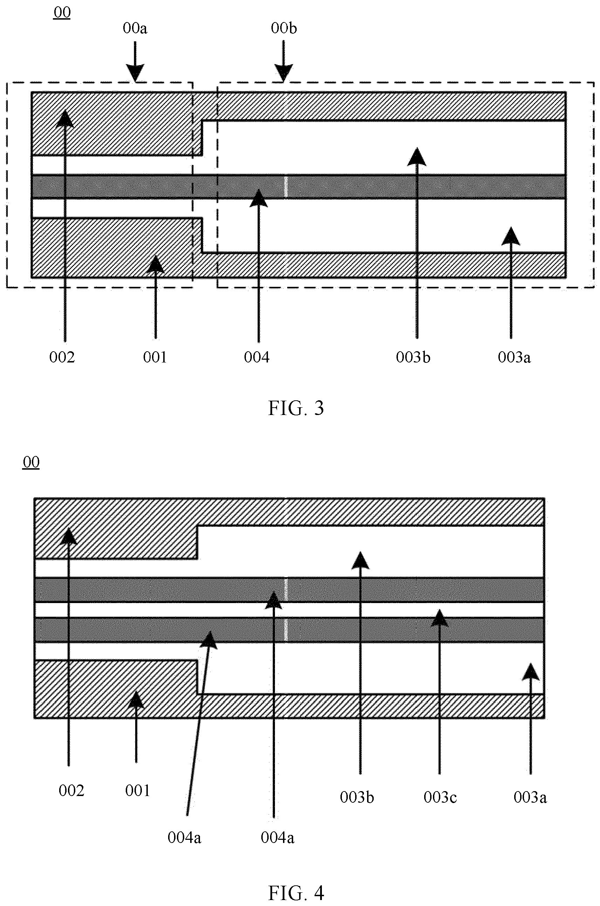

FIG. 3 is a schematic structural diagram of still another PCB board according to an embodiment of this application. Referring to FIG. 3, the PCB board 00 may further include N inner conducting layers 004 sandwiched between a first outer conducting layer 001 and a second outer conducting layer 002, where N may be a positive integer greater than or equal to 1. One insulation medium layer 003 may be disposed between each outer conducting layer (that is, the first outer conducting layer 001 and the second outer conducting layer 002) and an adjacent inner conducting layer 004, and one insulation medium layer 003 may also be disposed between two adjacent inner conducting layers 004. Therefore, a total quantity of insulation medium layers that are disposed on the PCB board 00 may be N + 1.

For example, on the PCB board 00 shown in FIG. 3, one inner conducting layer 004 (that is, N = 1) is sandwiched between the first outer conducting layer 001 and the second outer conducting layer 002. A first insulation medium layer 003a is sandwiched between the inner conducting layer 004 and the first outer conducting layer 001, and a second insulation medium layer 003b is sandwiched between the inner conducting layer 004 and the second outer conducting layer 002.

In this embodiment of this application, N may be an even number. That is, the PCB board 00 may include an even-numbered quantity of inner conducting layers. For example, the PCB board 00 may include two inner conducting layers or four inner conducting layers. The even-numbered quantity of inner conducting layers are disposed on the PCB board 00, so that symmetry of the PCB board 00 can be ensured. In addition, the PCB board 00 with the even-numbered quantity of inner layers does not require an additional core structure process and a foil coating process, so that processing costs are relatively low.

FIG. 4 is a schematic structural diagram of yet another PCB board according to an embodiment of this application. Referring to FIG. 4, two inner conducting layers 004 (that is, N = 2) may be disposed between a first outer conducting layer 001 and a second outer conducting layer 002. A first insulation medium layer 003a is sandwiched between a first inner conducting layer 004a and the first outer conducting layer 001. A second insulation medium layer 003b is sandwiched between a second inner conducting layer 004b and the first outer conducting layer 002. A third insulation medium layer 003c is sandwiched between the first inner conducting layer 004a and the second inner conducting layer 004b.

Optionally, there may be at least one target inner conducting layer in the N inner conducting layers 004, where a thickness of a part, of a gold finger area 00a, in which the target inner conducting layer is located may be greater than a thickness of a part, of a soldering area 00b, in which the target inner conducting layer is located. A thickness of a part, of the gold finger area 00a, in which an inner conducting layer other than the target inner conducting layer is located may be equal to a thickness of a part, of the soldering area 00b, in which the inner conducting layer is located, for example, may be equal to a thickness of a part, of the soldering area 00b, in which the target inner conducting layer is located.

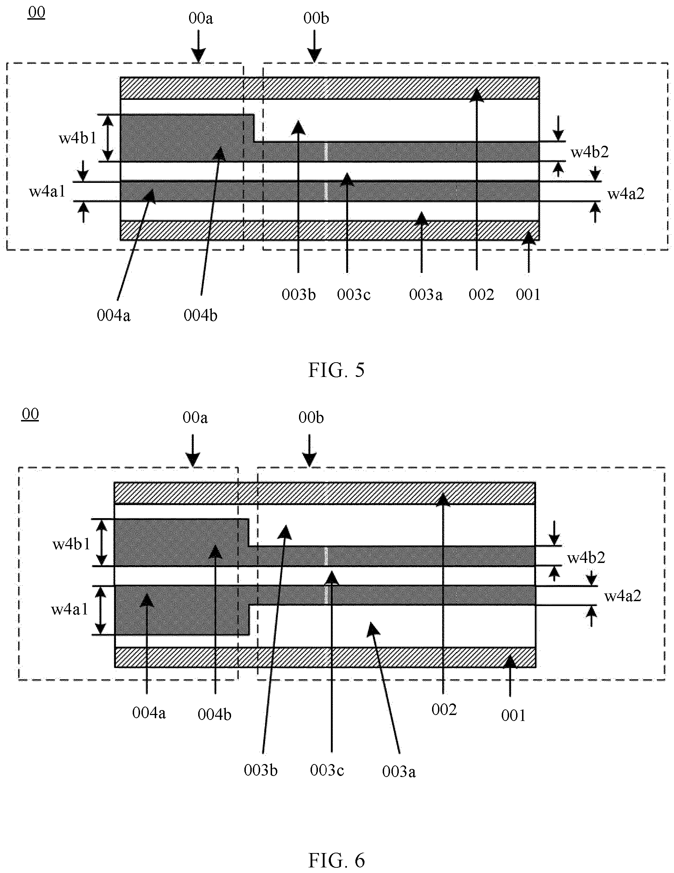

For example, FIG. 5 is a schematic structural diagram of yet another PCB board according to an embodiment of this application. Referring to FIG. 5, two inner conducting layers 004 (that is, N=2) are disposed between a first outer conducting layer 001 and a second outer conducting layer 002, a second inner conducting layer 004b is a target inner conducting layer, and a first inner conducting layer 004a is not the target inner conducting layer. Referring to FIG. 5, a thickness w4a1 of a part, of a gold finger area 00a, in which the first inner conducting layer 004a is located is equal to a thickness w4a2 of a part, of a soldering area 00b, in which the first inner conducting layer 004a is located, that is, w4a1 = w4a2. A thickness w4b1 of a part, of the gold finger area 00a, in which the second inner conducting layer 004b is located is greater than a thickness w4b2 of a part, of the soldering area 00b, in which the second inner conducting layer 004b is located, that is, w4b1 > w4b2. Referring to FIG. 5, it can also be seen that, a thickness of a part, of the gold finger area 00a, in which each outer conducting layer (that is, the first outer conducting layer 001 and the second outer conducting layer 002) is located may be equal to a thickness of a part, of the soldering area 00b, in which each outer conducting layer is located.

Alternatively, both the first outer conducting layer 001 and the second outer conducting layer 002 may target inner conducting layers. Referring to FIG. 6, the thickness w4a1 of the part, of the gold finger area 00a, in which the first inner conducting layer 004a is located is greater than the thickness w4a2 of the part, of the soldering area 00b, in which the first inner conducting layer 004a is located, that is, w4a1 > w4a2. The thickness w4b1 of the part, of the gold finger area 00a, in which the second inner conducting layer 004b is located is greater than the thickness w4b2 of the part, of the soldering area 00b, in which the second inner conducting layer 004b is located, that is, w4b1 > w4b2. Optionally, a thickness of a part, of the gold finger area 00a, in which the target inner conducting layer is located may range from 4 oz to 20 oz (0,1388 mm to 0,694 mm). A thickness of a part, of the soldering area 00b, in which the target inner conducting layer is located may range from 1/3 oz to 3 oz (0,0115666666666667 mm to 0,1041 mm). A thickness of a part, of the gold finger area 00a, in which an inner conducting layer other than the target inner conducting layer is located and a thickness of a part, of the soldering area 00b, in which the inner conducting layer is located may both range from 1/3 oz to 3 oz (0,0115666666666667 mm to 0,1041 mm).

For example, referring to FIG. 6, both the thickness of the part, of the gold finger area 00a, in which the first inner conducting layer 004a is located and the thickness of the part, of the gold finger area 00a, in which the second inner conducting layer 004b is located may be 10 oz (0,347 mm) (that is, w4a1 = w4b1 = 10 oz (0,347 mm)), and both the thickness of the part, of the soldering area 00b, in which the first inner conducting layer 004a is located and the thickness of the part, of the soldering area 00b, in which the second inner conducting layer 004b is located may be 2 oz (0,0694 mm) (that is, w4a2 = w4b2).

Alternatively, referring to FIG. 5, both the thickness w4a1 of the part, of the gold finger area 00a, in which the first inner conducting layer 004a is located and the thickness w4a2 of the part, of the soldering area 00b, in which the first inner conducting layer 004a is located may be 2 oz (0,0694 mm) (that is, w4a1 = w4a2 = 2 oz (0,0694 mm)). The thickness w4b1 of the part, of the gold finger area 00a, in which the second inner conducting layer 004b is located may be 10 oz (0,347 mm) (that is, w4b1 = 10 oz (0,347 mm)), and the thickness w4b2 of the part, of the soldering area 00b, in which the second inner conducting layer 004b is located may be 2 oz (0,0694 mm) (that is, w4b2 = 2 oz (0,0694 mm)).

It should be noted that, when the thickness of the part, of the gold finger area 00a, in which the inner conducting layer is located is greater than the thickness of the part, of the soldering area, in which the inner conducting layer is located, the part, of the gold finger area 00a, in which the inner conducting layer is located may protrude in a direction close to the first outer conducting layer 001, or may protrude in a direction close to the second outer conducting layer 002. This is not limited in this embodiment of this application.

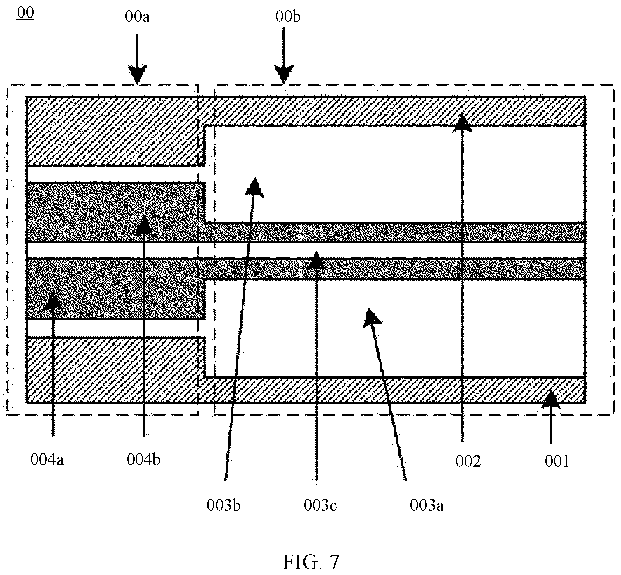

In this embodiment of this application, to effectively increase a total thickness of all conducting layers in the gold finger area 00a and improve a through-current capability of the gold finger area 00a, referring to FIG. 7, the thickness of the part, of the gold finger area 00a, in which each outer conducting layer is located may be greater than the thickness of the part, of the soldering area 00b, in which each outer conducting layer is located, and the thickness of the part, of the gold finger area 00a, in which each inner conducting layer is located may also be greater than the thickness of the part, of the soldering area 00b, in which each inner conducting layer is located.

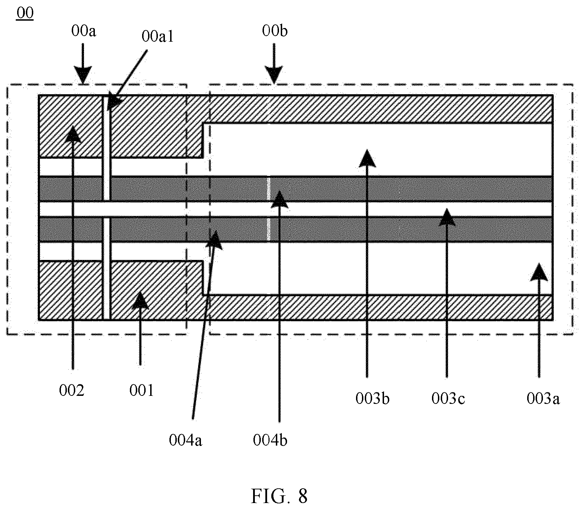

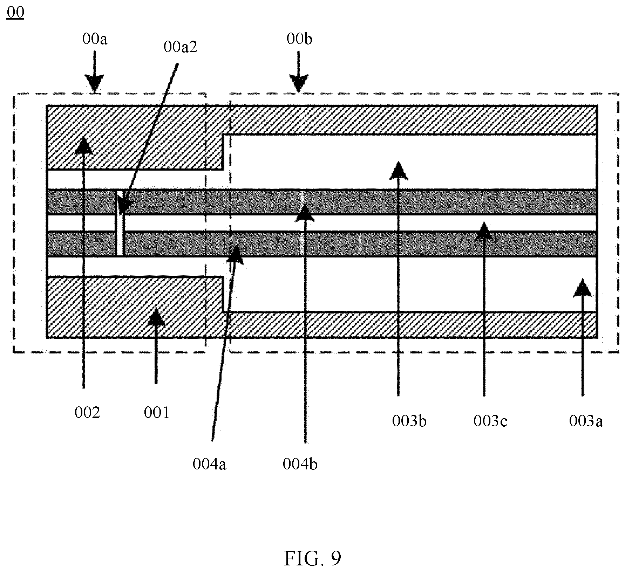

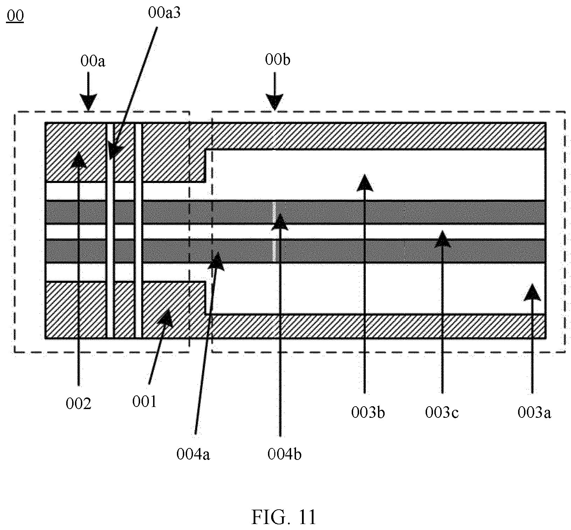

Optionally, referring to FIG. 8 to FIG. 14, for the PCB board 00 provided in this embodiment of this application, at least one of a blind via hole (blind via hole) 00a1, a buried via hole (buried via hole) 00a2, and a plating through hole (plating through hole) 00a3 may be disposed in the gold finger area 00a. The blind via hole 00a1 may be a via that connects the outer conducting layer and the inner conducting layer but does not penetrate the PCB board 00. For example, referring to FIG. 8, the blind via hole 00a1 may penetrate one outer conducting layer and at least one inner conducting layer. The buried via hole 00a2 may be a via that connects any two inner conducting layers but does not penetrate the outer conducting layer. For example, referring to FIG. 9, the buried via hole 00a2 may penetrate at least two inner conducting layers. The plating through hole 00a3 may be a via that connects the outer conducting layer and the inner conducting layer and penetrates all conducting layers on the PCB board 00. For example, referring to FIG. 11, the plating through hole 00a3 may penetrate the first outer conducting layer 001 and the second outer conducting layer 002. In addition, there may be one or more of vias of each type on the PCB board 00. This is not limited in this embodiment of this application.

For example, referring to FIG. 8, the blind via hole 00a1 may be disposed in the gold finger area 00a on the PCB board 00. For example, as shown in FIG. 8, two blind via holes 00a1 may be disposed. One blind via hole 00a1 may penetrate the first outer conducting layer 001 and the first inner conducting layer 004a, and the other blind via hole 00a1 may penetrate the second outer conducting layer 002 and the second inner conducting layer 004b.

Alternatively, referring to FIG. 9, one buried via hole 00a2 may be disposed in the gold finger area 00a on the PCB board 00. For example, as shown in FIG. 9, the buried via hole 00a2 may be disposed. The buried via hole 00a2 may penetrate the first inner conducting layer 004a and the second inner conducting layer 004b.

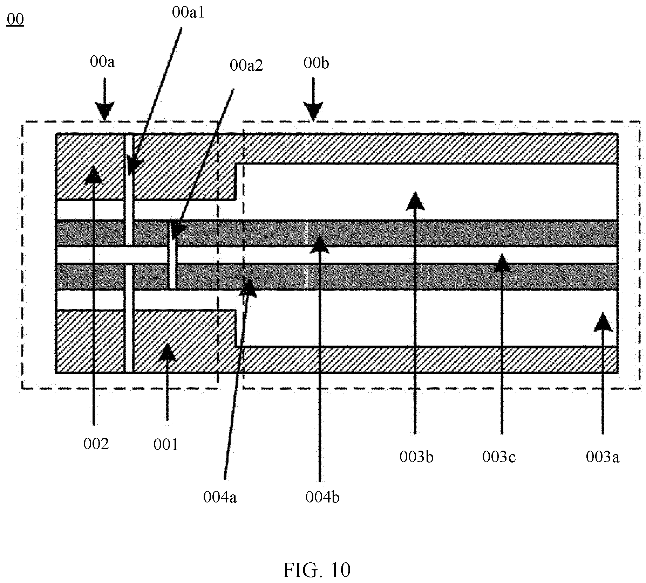

Alternatively, referring to FIG. 10, both the blind via hole 00a1 and the buried via hole 00a2 may be disposed in the gold finger area 00a on the PCB board 00. For example, as shown in FIG. 10, two blind via holes 00a1 and one buried via hole 00a2 may be disposed. One blind via hole 00al may penetrate the first outer conducting layer 001 and the first inner conducting layer 004a, and the other blind via hole 00a1 may penetrate the second outer conducting layer 002 and the second inner conducting layer 004b. The buried via hole 00a2 may penetrate the first inner conducting layer 004a and the second inner conducting layer 004b.

Alternatively, referring to FIG. 11, the plating through hole 00a3 may be disposed in the gold finger area 00a on the PCB board 00. For example, as shown in FIG. 11, two plating through holes 00a3 may be disposed. The two plating through holes 00a3 may penetrate the first outer conducting layer 001 and the second outer conducting layer 002.

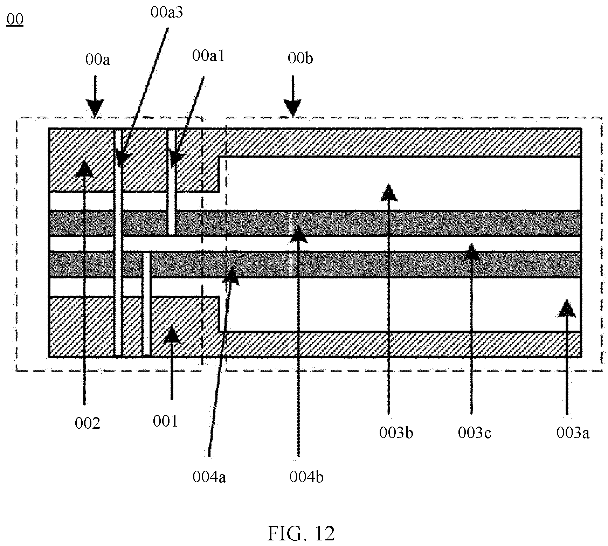

Alternatively, referring to FIG. 12, both the blind via hole 00a1 and the plating through hole 00a3 may be disposed in the gold finger area 00a on the PCB board 00. For example, as shown in FIG. 12, two blind via holes 00a1 and one plating through hole 00a3 may be disposed. One blind via hole 00a1 may penetrate the first outer conducting layer 001 and the first inner conducting layer 004a, and the other blind via hole 00a1 may penetrate the second outer conducting layer 002 and the second inner conducting layer 004b. The plating through hole 00a3 may penetrate the first outer conducting layer 001 and the second outer conducting layer 002.

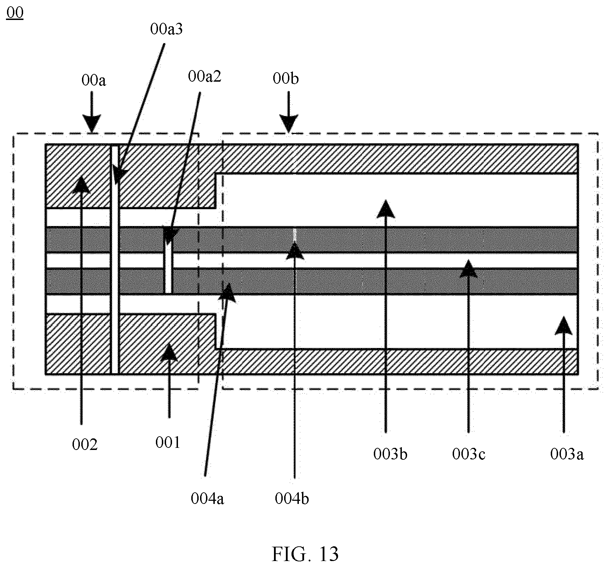

Alternatively, referring to FIG. 13, both the buried via hole 00a2 and the plating through hole 00a3 may be disposed in the gold finger area 00a. For example, as shown in FIG. 13, one buried via hole 00a2 and one plating through hole 00a3 may be disposed. The buried via hole 00a2 may penetrate the first inner conducting layer 004a and the second inner conducting layer 004b. The plating through hole 00a3 may penetrate the first outer conducting layer 001 and the second outer conducting layer 002.

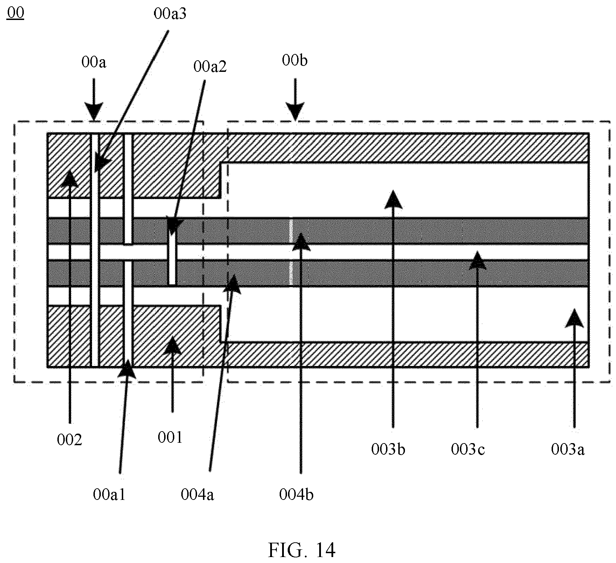

Alternatively, referring to FIG. 14, the blind via hole 00al, the buried via hole 00a2, and the plating through hole 00a3 may be all disposed in the gold finger area 00a. For example, as shown in FIG. 14, two blind via holes 00a1, one buried via hole 00a2, and one plating through hole 00a3 may be disposed. One blind via hole 00a1 may penetrate the first outer conducting layer 001 and the first inner conducting layer 004a, and the other blind via hole 00a1 may penetrate the second outer conducting layer 002 and the second inner conducting layer 004b. The buried via hole 00a2 may penetrate the first inner conducting layer 004a and the second inner conducting layer 004b. The plating through hole 00a3 may penetrate the first outer conducting layer 001 and the second outer conducting layer 002.

In this embodiment of this application, at least one via of the blind via hole 00a1, the buried via hole 00a2, and the plating through hole 00a3 is disposed to increase a heat dissipation capability of the PCB board 00. This reduces a temperature of the gold finger area 00a, reduces resistance of the gold finger area 00a, and improves the through-current capability of the gold finger area.

Optionally, a conducting material layer may be disposed on all side walls of the blind via hole 00a1, the buried via hole 00a2, and the plating through hole 00a3, so that conducting layers that are penetrated by the various types of vias are electrically connected. The conducting material layer may be a copper layer. The conducting material layer is disposed on the side wall of the via, so that the resistance of the gold finger area may be further reduced, and the through-current capability of the gold finger area is improved.

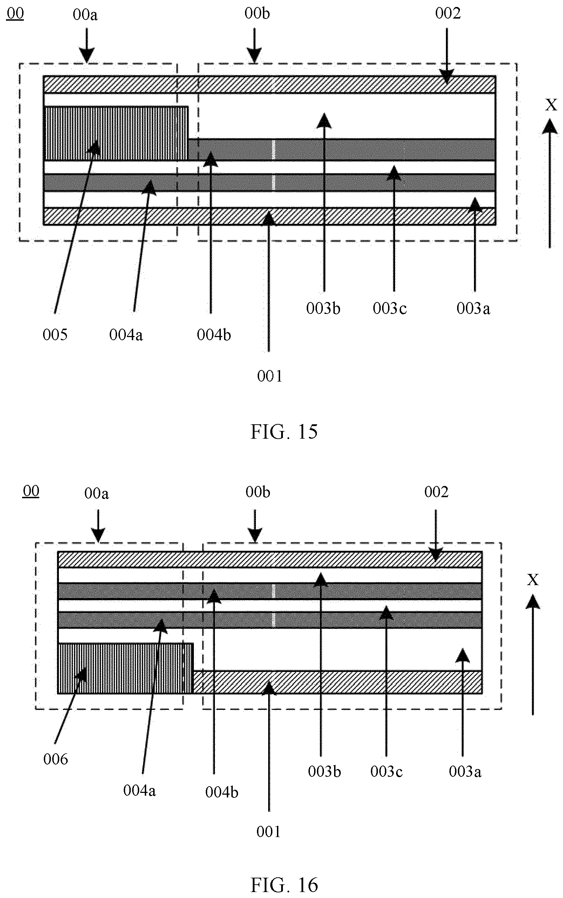

Optionally, as shown in FIG. 15, the PCB board 00 may further include M inner-layer conducting blocks 005 that are disposed in the gold finger area 00a and sandwiched between the first outer conducting layer 001 and the second outer conducting layer 002, where M may be a positive integer greater than or equal to 1.

At least one of the M inner-layer conducting blocks 005 may be electrically connected to one inner conducting layer 004. For example, referring to FIG. 15, an end face of the inner-layer conducting block 005 may be in contact with an end face of the second inner conducting layer 004b, and a surface that is of the inner-layer conducting block 005 and that is close to the first outer conducting layer 001 is coplanar with a surface that is of the second inner conducting layer 004b and that is close to the first outer conducting layer 001. The inner-layer conducting block 005 is connected to one inner conducting layer 004, so that the through-current capability of the gold finger area 00a on the PCB board 00 can be further improved. The end face may be parallel to a thickness direction X of the PCB board 00.

In this embodiment of this application, the PCB board 00 may further include at least one outer-layer conducting block disposed in the gold finger area 00a. The at least one outer-layer conducting block may include at least one of a first outer-layer conducting block 006 and a second outer-layer conducting block 007.

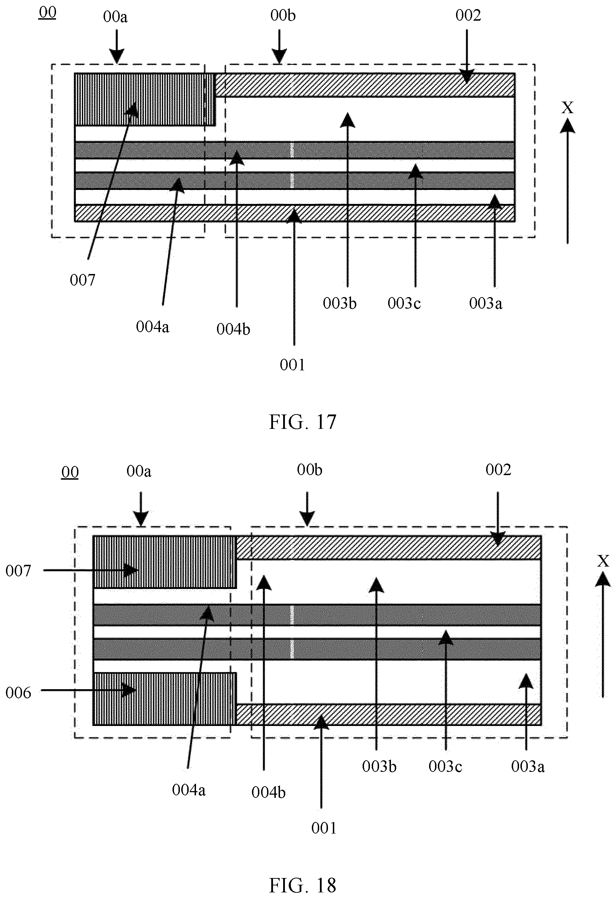

Referring to FIG. 16, an end face of the first outer-layer conducting block 006 may be in contact with an end face of the first outer conducting layer 001, and a surface that is of the first outer-layer conducting block 006 and that is far away from the second outer conducting layer 002 is coplanar with a surface that is of the first outer conducting layer 001 and that is far away from the second outer conducting layer 002. Referring to FIG. 17, an end face of the second outer-layer conducting block 007 may be in contact with an end face of the second outer conducting layer 002, and a surface that is of the second outer-layer conducting block 007 and that is far away from the first outer conducting layer 001 is coplanar with a surface that is of the second outer conducting layer 002 and that is far away from the first outer conducting layer 001. The end face may be parallel to a thickness direction X of the PCB board 00.

It can be learned from the foregoing descriptions that the first outer-layer conducting block 006 and the second outer-layer conducting block 007 are conducting blocks that are located on a surface of the PCB board 00. The outer conductive block is disposed on the surface of the PCB board 00, so that the heat dissipation capability of the PCB board 00 can be effectively improved, the resistance of the gold finger area 00a on the PCB board 00 is reduced, and the through-current capability of the gold finger area 00a is improved.

For example, referring to FIG. 16, the PCB board 00 may include only one first outer-layer conducting block 006. Alternatively, referring to FIG. 17, the PCB board 00 may include only one second outer-layer conducting block 007. Alternatively, referring to FIG. 18, the PCB board 00 may include one first outer-layer conducting block 006 and one second outer-layer conducting block 007.

Optionally, in this embodiment of this application, each inner-layer conducting block 005 and each outer-layer conducting block may be copper blocks.

It should be noted that, for at least one structure (for example, the structure shown in FIG. 15 to FIG. 18) of the inner-layer conducting block 005 or the outer-layer conducting block disposed on the PCB board 00, at least one via of the blind via hole 00a1, and the buried via hole 00a2, and the plating through hole 00a3 may also be disposed in the gold finger area 00a on the PCB board 00.

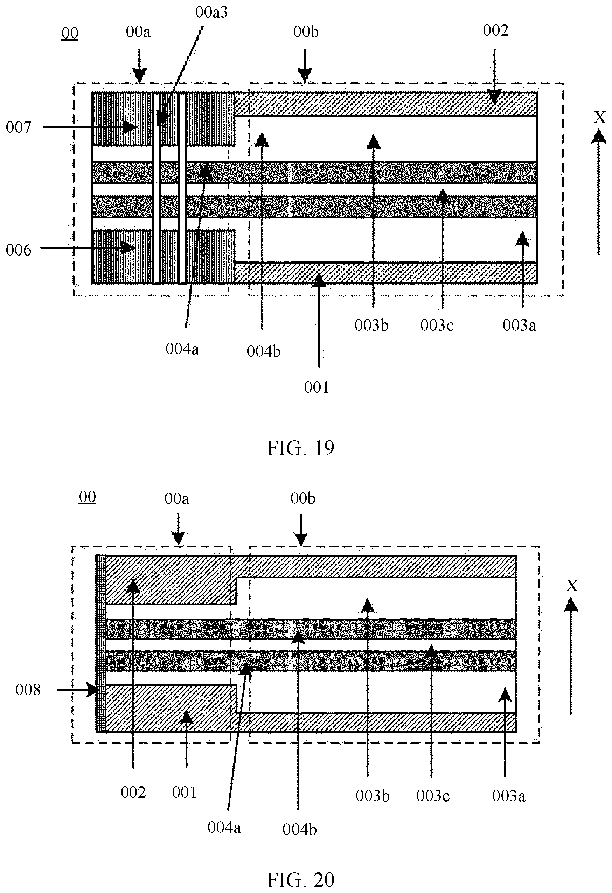

For example, referring to FIG. 19, the PCB board 00 includes the first outer conducting layer 001, the second outer conducting layer 002, and at least one insulation medium layer 003 and at least one inner conducting layer 004 that are sandwiched between the first outer conducting layer 001 and the second outer conducting layer 002. The PCB board 00 includes the first outer-layer conducting block 006 and the second outer-layer conducting block 007. Two plating through holes 00a3 are disposed in the gold finger area 00a on the PCB board 00. The two plating through holes 00a3 may penetrate the first outer-layer conducting block 006 and the second outer-layer conducting block 007. In this embodiment of this application, referring to FIG. 20, the PCB board 00 may further include a conducting side wall 008. The conducting side wall 008 may be connected to end faces of all conducting layers in the gold finger area 00a, where the end face may be parallel to the thickness direction X of the PCB board 00.

Optionally, the conducting side wall 008 may be a layer of conductive metal. When the conducting side wall 008 is formed, the end surfaces of all the conducting layers may be polished first, and then the conducting side wall 008 may be formed on the end surfaces of all the conducting layers by using a chemical plating or electroplating method. All the conducting layers in the gold finger area 00a may be electrically connected by disposing the conducting side wall 008, so that the through-current capability of the gold finger area 00a is further improved.

For example, referring to FIG. 20, the PCB board 00 includes the first outer conducting layer 001, the second outer conducting layer 002, and at least one insulation medium layer 003 and at least one inner conducting layer 004 that are sandwiched between the first outer conducting layer 001 and the second outer conducting layer 002. The conducting side wall 008 may be disposed at one end of all the conducting layers in the gold finger area 00a on the PCB board 00.

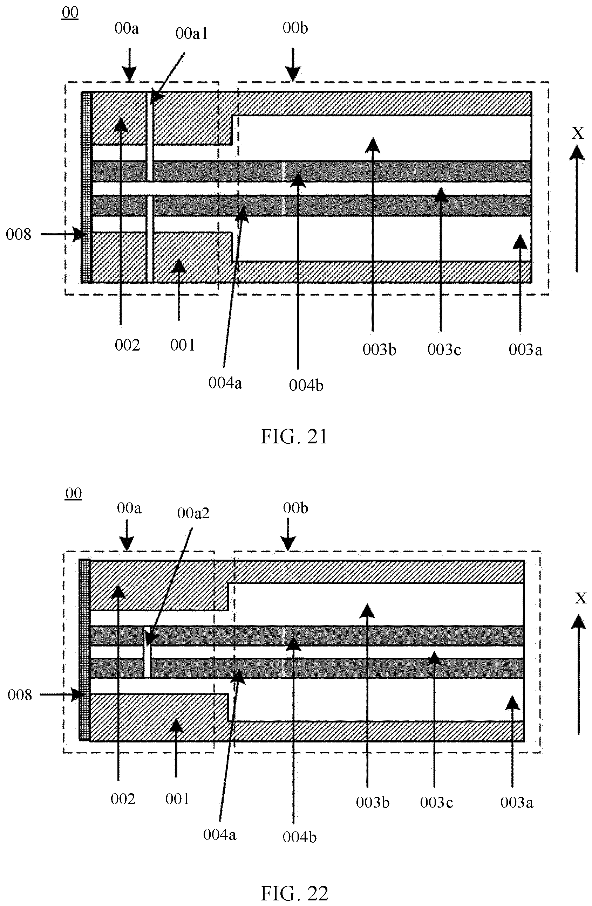

Referring to FIG. 21, the blind via hole 00a1 may be disposed in the gold finger area 00a. For example, as shown in FIG. 21, two blind via holes 00a1 may be disposed. One blind via hole 00a1 may penetrate the first outer conducting layer 001 and the first inner conducting layer 004a, and the other blind via hole 00a1 may penetrate the second outer conducting layer 002 and the second inner conducting layer 004b.

Referring to FIG. 22, the buried via hole 00a2 may be disposed in the gold finger area 00a. For example, as shown in FIG. 22, the buried via hole 00a2 may be disposed. The buried via hole 00a2 may penetrate the first inner conducting layer 004a and the second inner conducting layer 004b.

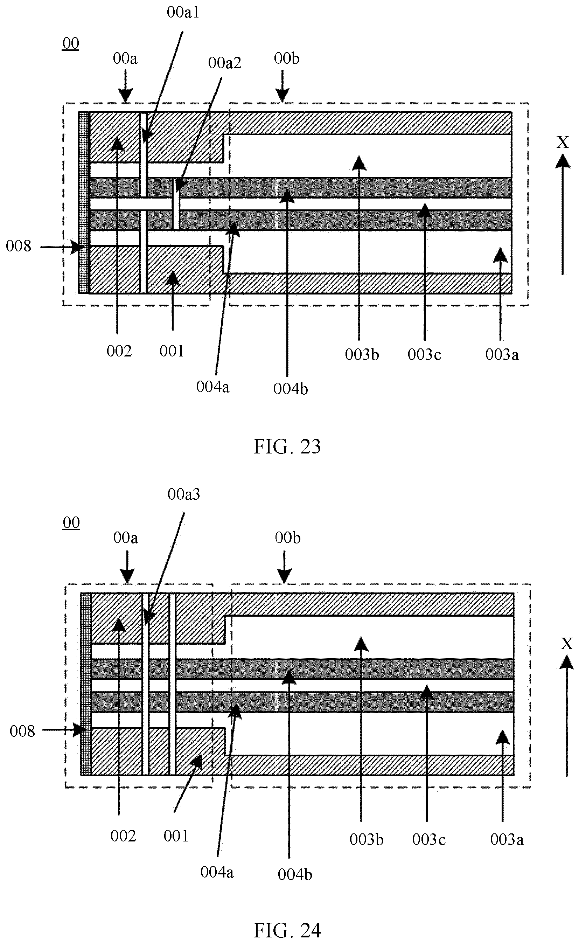

Referring to FIG. 23, both the blind via hole 00a1 and the buried via hole 00a2 may be disposed in the gold finger area 00a. For example, as shown in FIG. 23, two blind via holes 00a1 and one buried via hole 00a2 may be disposed. One blind via hole 00a1 may penetrate the first outer conducting layer 001 and the first inner conducting layer 004a, and the other blind via hole 00a1 may penetrate the second outer conducting layer 002 and the second inner conducting layer 004b. The buried via hole 00a2 may penetrate the first inner conducting layer 004a and the second inner conducting layer 004b.

Referring to FIG. 24, the plating through hole 00a3 may be disposed in the gold finger area 00a. For example, as shown in FIG. 24, two plating through holes 00a3 may be disposed. The two plating through holes 00a3 may penetrate the first outer conducting layer 001 and the second outer conducting layer 002.

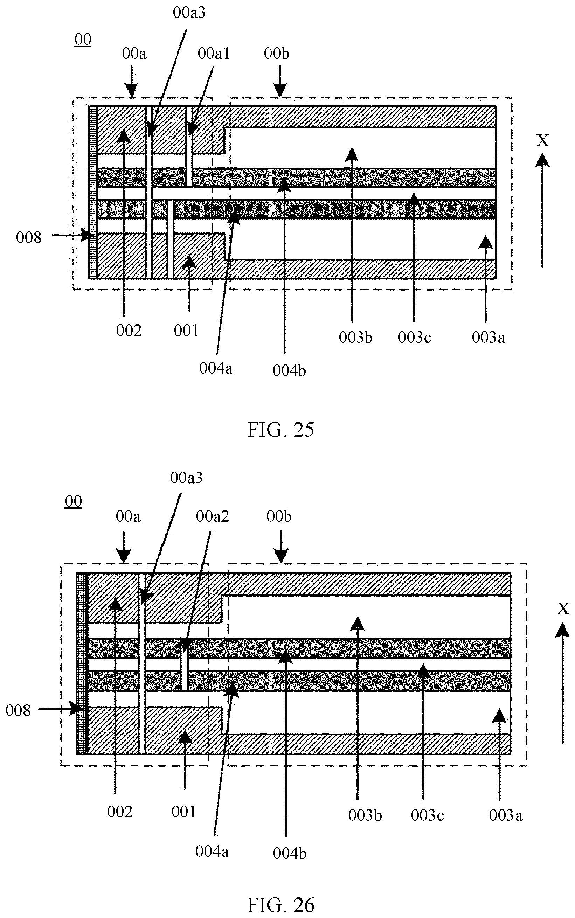

Referring to FIG. 25, both the blind via hole 00a1 and the plating through hole 00a3 may be disposed in the gold finger area 00a. For example, as shown in FIG. 25, two blind via holes 00a1 and one plating through hole 00a3 may be disposed. One blind via hole 00a1 may penetrate the first outer conducting layer 001 and the first inner conducting layer 004a, and the other blind via hole 00a1 may penetrate the second outer conducting layer 002 and the second inner conducting layer 004b. The plating through hole 00a3 may penetrate the first outer conducting layer 001 and the second outer conducting layer 002.

Referring to FIG. 26, both the buried via hole 00a2 and the plating through hole 00a3 may be disposed in the gold finger area 00a. For example, as shown in FIG. 26, one buried via hole 00a2 and one plating through hole 00a3 may be disposed. The buried via hole 00a2 may penetrate the first inner conducting layer 004a and the second inner conducting layer 004b. The plating through hole 00a3 may penetrate the first outer conducting layer 001 and the second outer conducting layer 002.

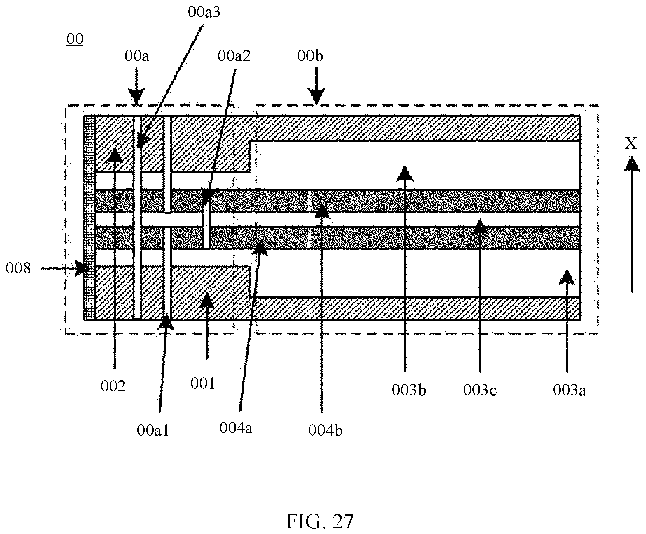

Referring to FIG. 27, the blind via hole 00a1, the buried via hole 00a2, and the plating through hole 00a3 may be all disposed in the gold finger area 00a. For example, as shown in FIG. 27, two blind via holes 00a1, one buried via hole 00a2, and one plating through hole 00a3 may be disposed. One blind via hole 00a1 may penetrate the first outer conducting layer 001 and the first inner conducting layer 004a, and the other blind via hole 00a1 may penetrate the second outer conducting layer 002 and the second inner conducting layer 004b. The buried via hole 00a2 may penetrate the first inner conducting layer 004a and the second inner conducting layer 004b. The plating through hole 00a3 may penetrate the first outer conducting layer 001 and the second outer conducting layer 002.

According to the PCB board provided in this embodiment of this application, when at least one of the first outer-layer conducting block 006 and the second outer-layer conducting block 007 is used, the heat dissipation capability of the gold finger area 00a on the PCB board can be effectively improved. Under a same condition, when the PCB board provided in this embodiment of this application is working, a temperature rise (that is, an amplitude of the temperature rise) of the gold finger area may be 10 degrees to 20 degrees lower than a temperature rise of a gold finger area on the PCB board in a related technology. Therefore, this can reduce the resistance of the gold finger area and improve the through-current capability of the gold finger area. For example, the PCB board provided in this embodiment of this application may allow a current greater than 250 A (ampere) to pass through.

In conclusion, the embodiments of this application provide the PCB board. On the PCB board, the total thickness of all conducting layers in the gold finger area is greater than the total thickness of all conducting layers in the soldering area. Because the total thickness of all conducting layers in the gold finger area is set to be relatively thick, the resistance of the gold finger area can be reduced, and the through-current capability of the gold finger area is improved. In addition, the total thickness of all conducting layers in the soldering area is set to be relatively thin, so that the sufficient soldering temperature and the good soldering effect can be ensured when electronic parts and components are soldered to the soldering area.

An embodiment of this application further provides a power supply. The power supply may include electronic parts and components and the PCB board shown in any one of FIG. 1 to FIG. 27. The electronic parts and components may be soldered to a soldering region 00b on the PCB board.

An embodiment of this application further provides a power supply system. The power supply system may include the foregoing power supply and a female socket connector. A gold finger on a PCB board of the power supply may be inserted into the female socket connector. The female socket connector may be a power connector.

## Claims

1. A printed circuit board (00), wherein the printed circuit board (00) comprises a first outer conducting layer (001), a second outer conducting layer (002), and at least one insulation medium layer (003) sandwiched between the first outer conducting layer (001) and the second outer conducting layer (002); and
the printed circuit board (00) comprises a gold finger area (00a) and a soldering area (00b), wherein
a total thickness of all conducting layers in the gold finger area (00a) is greater than a total thickness of all conducting layers in the soldering area (00b), **characterised in that**
a total thickness of the gold finger area (00a) is equal to a total thickness of the soldering area (00b) on the printed circuit board (00).

2. The printed circuit board (00) according to claim 1, wherein
there is at least one target outer conducting layer in the first outer conducting layer (001) and the second outer conducting layer (002), wherein a thickness of a part, of the gold finger area (00a), in which the target outer conducting layer is located is greater than a thickness of a part, of the soldering area (00b), in which the target outer conducting layer is located.

3. The printed circuit board (00) according to claim 2, wherein
the thickness of the part, of the gold finger area (00a), in which the target outer conducting layer is located ranges from 4 oz to 20 oz (0,1388 mm to 0,694 mm); and
the thickness of the part, of the soldering area (00b), in which the target outer conducting layer is located ranges from 1/3 oz to 3 oz (0,0115666666666667 mm to 0,1041 mm).

4. The printed circuit board (00) according to any one of claims 1 to 3, wherein the printed circuit board (00) further comprises N inner conducting layers (004) sandwiched between the first outer conducting layer (001) and the second outer conducting layer (002), wherein N is a positive integer greater than or equal to 1;
one insulation medium layer (003) is sandwiched between each outer conducting layer (001, 002) and an adjacent inner conducting layer (004); and
one insulation medium layer (003) is sandwiched between two adjacent inner conducting layers (004).

5. The printed circuit board (00) according to claim 4, wherein
there is at least one target inner conducting layer in the N inner conducting layers (004), wherein a thickness of a part, of the gold finger area (00a), in which the target inner conducting layer is located is greater than a thickness of a part, of the soldering area (00b), in which the target inner conducting layer is located.

6. The printed circuit board (00) according to claim 5, wherein
the thickness of the part, of the gold finger area (00a), in which the target inner conducting layer is located ranges from 4 oz to 20 oz (0,1388 mm to 0,694 mm); and
the thickness of the part, of the soldering area (00b), in which the target inner conducting layer is located ranges from 1/3 oz to 3 oz (0,0115666666666667 mm to 0,1041 mm).

7. The printed circuit board (00) according to claim 5, wherein N is an even number.

8. The printed circuit board (00) according to claim 7, wherein
at least one via of a blind via hole (00a1) and a buried via hole (00a2) is disposed in the gold finger area (00a), wherein
the blind via hole (00a1) penetrates one outer conducting layer (001, 002) and at least one inner conducting layer (004); and
the buried via hole (00a2) penetrates at least two inner conducting layers (004).

9. The printed circuit board (00) according to any one of claims 1 to 8, wherein
a plating through hole (00a3) is disposed in the gold finger area (00a), wherein
the plating through hole (00a3) penetrates the first outer conducting layer (001) and the second outer conducting layer (002).

10. The printed circuit board (00) according to any one of claims 4 to 9, wherein the printed circuit board (00) further comprises M inner-layer conducting blocks (005) that are disposed in the gold finger area (00a) and sandwiched between the first outer conducting layer (001) and the second outer conducting layer (002), wherein M is a positive integer greater than or equal to 1; and
at least one of the M inner-layer conducting blocks (005) is electrically connected to one inner conducting layer (004).

11. The printed circuit board (00) according to any one of claims 1 to 10, wherein the printed circuit board (00) further comprises at least one outer-layer conducting block of a first outer-layer conducting block (006) and a second outer-layer conducting block (007) that are disposed in the gold finger area (00a), wherein
an end face of the first outer-layer conducting block (006) is in contact with an end face of the first outer conducting layer (001), and a surface that is of the first outer-layer conducting block (006) and that is far away from the second outer conducting layer (002) is coplanar with a surface that is of the first outer conducting layer (001) and that is far away from the second outer conducting layer (002); and
an end face of the second outer-layer conducting block (007) is in contact with an end face of the second outer conducting layer (002), and a surface that is of the second outer-layer conducting block (007) and that is far away from the first outer conducting layer (001) is coplanar with a surface that is of the second outer conducting layer (002) and that is far away from the first outer conducting layer (001); wherein
the end face is parallel to a thickness direction of the printed circuit board (00).

12. The printed circuit board (00) according to any one of claims 1 to 11, wherein the printed circuit board (00) further comprises a conducting side wall (008), wherein
the conducting side wall (008) is connected to end faces of all conducting layers (001, 002, 004) in the gold finger area (00a), wherein the end face is parallel to the thickness direction of the printed circuit board (00).

13. A power supply, wherein the power supply comprises electronic parts and components and the printed circuit board (00) according to any one of claims 1 to 12, wherein
the electronic parts and components are soldered to the soldering area (00b) on the printed circuit board (00).

14. A power supply system, wherein the power supply system comprises the power supply according to claim 13 and a female socket connector, wherein
in the power supply, a gold finger on a printed circuit board (00) is inserted into the female socket connector.

## Patentansprüche

1. Leiterplatte (00), wobei die Leiterplatte (00) eine erste äußere leitende Schicht (001), eine zweite äußere leitende Schicht (002) und mindestens eine zwischen der ersten äußeren leitenden Schicht (001) und der zweiten äußeren leitenden Schicht (002) angeordnete Isoliermediumschicht (003) umfasst; und
die Leiterplatte (00) einen Goldfingerbereich (00a) und einen Lötbereich (00b) aufweist, wobei
eine Gesamtdicke aller leitenden Schichten im Goldfingerbereich (00a) größer ist als eine Gesamtdicke aller leitenden Schichten im Lötbereich (00b), **dadurch gekennzeichnet, dass**
eine Gesamtdicke des Goldfingerbereichs (00a) einer Gesamtdicke des Lötbereichs (00b) auf der Leiterplatte (00) gleich ist.

2. Leiterplatte (00) nach Anspruch 1, wobei
in der ersten äußeren leitenden Schicht (001) und der zweiten äußeren leitenden Schicht (002) mindestens eine äußere Zielleiterschicht vorhanden ist, wobei eine Dicke eines Teils des Goldfingerbereichs (00a), in dem sich die äußere Zielleiterschicht befindet, größer ist als eine Dicke eines Teils des Lötbereichs (00b), in dem sich die äußere Zielleiterschicht befindet.

3. Leiterplatte (00) nach Anspruch 2, wobei
die Dicke des Teils des Goldfingerbereichs (00a), in dem sich die äußere leitende Schicht befindet, 4 oz bis 20 oz (0,1388 mm bis 0,694 mm) beträgt; und
die Dicke des Teils des Lötbereichs (00b), in dem sich die äußere leitende Schicht befindet, 1/3 oz bis 3 oz (0,0115666666666667 mm bis 0,1041 mm) beträgt.

4. Leiterplatte (00) nach einem der Ansprüche 1 bis 3, wobei die Leiterplatte (00) ferner N innere leitende Schichten (004) umfasst, die zwischen der ersten äußeren leitenden Schicht (001) und der zweiten äußeren leitenden Schicht (002) angeordnet sind, wobei N eine positive ganze Zahl größer oder gleich 1 ist;
eine Isoliermediumschicht (003) zwischen jeder äußeren leitenden Schicht (001, 002) und einer benachbarten inneren leitenden Schicht (004) angeordnet ist; und
eine Isoliermediumschicht (003) zwischen zwei benachbarten inneren leitenden Schichten (004) angeordnet ist.

5. Leiterplatte (00) nach Anspruch 4, wobei
sich in den N inneren leitenden Schichten (004) mindestens eine innere Zielleiterschicht befindet, wobei eine Dicke eines Teils des Goldfingerbereichs (00a), in dem sich die innere Zielleiterschicht befindet, größer ist als eine Dicke eines Teils des Lötbereichs (00b), in dem sich die innere Zielleiterschicht befindet.

6. Leiterplatte (00) nach Anspruch 5, wobei
die Dicke des Teils des Goldfingerbereichs (00a), in dem sich die innere leitende Schicht befindet, 4 oz bis 20 oz (0,1388 mm bis 0,694 mm) beträgt; und
die Dicke des Teils des Lötbereichs (00b), in dem sich die innere leitende Schicht befindet, 1/3 oz bis 3 oz (0,0115666666666667 mm bis 0,1041 mm) beträgt.

7. Leiterplatte (00) nach Anspruch 5, wobei N eine gerade Zahl ist.

8. Leiterplatte (00) nach Anspruch 7, wobei
mindestens eine Durchkontaktierung aus einem blinden Durchkontaktierungsloch (00a1) und einem vergrabenen Durchkontaktierungsloch (00a2) im Goldfingerbereich (00a) angeordnet ist, wobei
das blinde Durchkontaktierungsloch (00a1) eine äußere leitende Schicht (001, 002) und mindestens eine innere leitende Schicht (004) durchdringt; und
das vergrabene Durchkontaktierungsloch (00a2) mindestens zwei innere leitende Schichten (004) durchdringt.

9. Leiterplatte (00) nach einem der Ansprüche 1 bis 8, wobei
ein Durchkontaktierungsloch (00a3) im Goldfingerbereich (00a) angeordnet ist, wobei
das Durchkontaktierungsloch (00a3) die erste äußere leitende Schicht (001) und die zweite äußere leitende Schicht (002) durchdringt.

10. Leiterplatte (00) nach einem der Ansprüche 4 bis 9, wobei die Leiterplatte (00) ferner M leitende Innenschichtblöcke (005) umfasst, die im Goldfingerbereich (00a) angeordnet und zwischen der ersten äußeren leitenden Schicht (001) und der zweiten äußeren leitenden Schicht (002) eingeschlossen sind, wobei M eine positive ganze Zahl größer oder gleich 1 ist; und
mindestens einer der M leitende Innenschichtblöcke (005) ist elektrisch mit einer inneren leitenden Schicht (004) verbunden.

11. Leiterplatte (00) nach einem der Ansprüche 1 bis 10, wobei die Leiterplatte (00) ferner mindestens einen leitenden Außenschichtblock aus einem ersten leitenden Außenschichtblock (006) und einem zweiten leitenden Außenschichtblock (007) umfasst, die im Goldfingerbereich (00a) angeordnet sind, wobei
eine Endfläche des ersten leitenden Außenschichtblocks (006) in Kontakt mit einer Endfläche der ersten äußeren leitenden Schicht (001) ist, und eine Oberfläche des ersten leitenden Außenschichtblocks (006), die weit von der zweiten äußeren leitenden Schicht (002) entfernt ist, koplanar mit einer Oberfläche der ersten äußeren leitenden Schicht (001) ist, die weit von der zweiten äußeren leitenden Schicht (002) entfernt ist; und
eine Endfläche des zweiten leitenden Außenschichtblocks (007) in Kontakt mit einer Endfläche der zweiten äußeren leitenden Schicht (002) ist, und eine Oberfläche des zweiten leitenden Außenschichtblocks (007), die weit von der ersten äußeren leitenden Schicht (001) entfernt ist, koplanar mit einer Oberfläche der zweiten äußeren leitenden Schicht (002) ist, die weit von der ersten äußeren leitenden Schicht (001) entfernt ist; wobei
die Endfläche parallel zu einer Dickenrichtung der Leiterplatte (00) verläuft.

12. Leiterplatte (00) nach einem der Ansprüche 1 bis 11, wobei die Leiterplatte (00) ferner eine leitende Seitenwand (008) umfasst, wobei
die leitende Seitenwand (008) mit den Endflächen aller leitenden Schichten (001, 002, 004) im Goldfingerbereich (00a) verbunden ist, wobei die Endfläche parallel zur Dickenrichtung der Leiterplatte (00) verläuft.

13. Stromversorgung, wobei die Stromversorgung elektronische Teile und Komponenten und die Leiterplatte (00) nach einem der Ansprüche 1 bis 12 umfasst, wobei
die elektronischen Teile und Komponenten auf der Lötfläche (00b) auf der Leiterplatte (00) verlötet werden.

14. Stromversorgungssystem, wobei das Stromversorgungssystem die Stromversorgung nach Anspruch 13 und einen Buchsenverbinder umfasst, wobei
in der Stromversorgung ein Goldfinger auf einer Leiterplatte (00) in die Buchsenleiste eingesteckt wird.

## Revendications

1. Carte de circuit imprimé (00), dans laquelle la carte de circuit imprimé (00) comprend une première couche conductrice externe (001), une seconde couche conductrice externe (002) et au moins une couche de milieu isolant (003) prise en sandwich entre la première couche conductrice externe (001) et la seconde couche conductrice externe (002) ; et
la carte de circuit imprimé (00) comprend une zone de doigt d'or (00a) et une zone de soudure (00b), dans laquelle
une épaisseur totale de toutes les couches conductrices dans la zone de doigt d'or (00a) est supérieure à une épaisseur totale de toutes les couches conductrices dans la zone de soudure (00b), **caractérisée en ce que**
une épaisseur totale de la zone de doigt d'or (00a) est égale à une épaisseur totale de la zone de soudure (00b) sur la carte de circuit imprimé (00).

2. Carte de circuit imprimé (00) selon la revendication 1, dans laquelle
il y a au moins une couche conductrice externe cible dans la première couche conductrice externe (001) et la seconde couche conductrice externe (002), dans laquelle une épaisseur d'une partie, de la zone de doigt d'or (00a), dans laquelle se situe la couche conductrice externe cible est supérieure à une épaisseur d'une partie, de la zone de soudure (00b), dans laquelle se situe la couche conductrice externe cible.

3. Carte de circuit imprimé (00) selon la revendication 2, dans laquelle
l'épaisseur de la partie, de la zone de doigt d'or (00a), dans laquelle se situe la couche conductrice externe cible est dans la plage de 4 oz à 20 oz (0,1388 mm à 0,694 mm) ; et
l'épaisseur de la partie, de la zone de soudure (00b), dans laquelle se situe la couche conductrice externe cible est dans la plage de 1/3 oz à 3 oz (0,0115666666666667 mm à 0,1041 mm).

4. Carte de circuit imprimé (00) selon l'une quelconque des revendications 1 à 3, dans laquelle la carte de circuit imprimé (00) comprend également N couches conductrices internes (004) prises en sandwich entre la première couche conductrice externe (001) et la seconde couche conductrice externe (002), dans laquelle N est un entier positif supérieur ou égal à 1 ;
une couche de milieu isolant (003) est prise en sandwich entre chaque couche conductrice externe (001, 002) et une couche conductrice interne adjacente (004) ; et
une couche de milieu isolant (003) est prise en sandwich entre deux couches conductrices internes adjacentes (004).

5. Carte de circuit imprimé (00) selon la revendication 4, dans laquelle
il y a au moins une couche conductrice interne cible dans les N couches conductrices internes (004), dans laquelle une épaisseur d'une partie, de la zone de doigt d'or (00a), dans laquelle se situe la couche conductrice interne cible est supérieure à une épaisseur d'une partie, de la zone de soudure (00b), dans laquelle se situe la couche conductrice interne cible.

6. Carte de circuit imprimé (00) selon la revendication 5, dans laquelle
l'épaisseur de la partie, de la zone de doigt d'or (00a), dans laquelle se situe la couche conductrice interne cible est dans la plage de 4 oz à 20 oz (0,1388 mm à 0,694 mm) ; et
l'épaisseur de la partie, de la zone de soudure (00b), dans laquelle se situe la couche conductrice interne cible est dans la plage de 1/3 oz à 3 oz (0,0115666666666667 mm à 0,1041 mm).

7. Carte de circuit imprimé (00) selon la revendication 5, dans laquelle N est un nombre pair.

8. Carte de circuit imprimé (00) selon la revendication 7, dans laquelle
au moins un trou d'interconnexion parmi un trou d'interconnexion borgne (00a1) et un trou d'interconnexion enterré (00a2) est disposé dans la zone de doigt d'or (00a), dans laquelle
le trou d'interconnexion borgne (00a1) pénètre une couche conductrice externe (001, 002) et au moins une couche conductrice interne (004) ; et
le trou d'interconnexion enterré (00a2) pénètre au moins deux couches conductrices internes (004).

9. Carte de circuit imprimé (00) selon l'une quelconque des revendications 1 à 8, dans laquelle
un trou traversant de placage (00a3) est disposé dans la zone de doigt d'or (00a), dans laquelle
le trou traversant de placage (00a3) pénètre la première couche conductrice externe (001) et la seconde couche conductrice externe (002).

10. Carte de circuit imprimé (00) selon l'une quelconque des revendications 4 à 9, dans laquelle la carte de circuit imprimé (00) comprend également M blocs conducteurs de couche interne (005) qui sont disposés dans la zone de doigt d'or (00a) et pris en sandwich entre la première couche conductrice externe (001) et la seconde couche conductrice externe (002), dans laquelle M est un entier positif supérieur ou égal à 1 ; et
au moins l'un des M blocs conducteurs de couche interne (005) est connecté électriquement à une couche conductrice interne (004).

11. Carte de circuit imprimé (00) selon l'une quelconque des revendications 1 à 10, dans laquelle la carte de circuit imprimé (00) comprend également au moins un bloc conducteur de couche externe parmi un premier bloc conducteur de couche externe (006) et un second bloc conducteur de couche externe (007) qui sont disposés dans la zone de doigt d'or (00a), dans laquelle
une face d'extrémité du premier bloc conducteur de couche externe (006) est en contact avec une face d'extrémité de la première couche conductrice externe (001), et une surface qui appartient au premier bloc conducteur de couche externe (006) et qui est éloignée de la seconde couche conductrice externe (002) est coplanaire avec une surface qui appartient à la première couche conductrice externe (001) et qui est éloignée de la seconde couche conductrice externe (002) ; et
une face d'extrémité du second bloc conducteur de couche externe (007) est en contact avec une face d'extrémité de la seconde couche conductrice externe (002), et une surface qui appartient au second bloc conducteur de couche externe (007) et qui est éloignée de la première couche conductrice externe (001) est coplanaire avec une surface qui appartient à la seconde couche conductrice externe (002) et qui est éloignée de la première couche conductrice externe (001) ; dans laquelle
la face d'extrémité est parallèle à une direction d'épaisseur de la carte de circuit imprimé (00).

12. Carte de circuit imprimé (00) selon l'une quelconque des revendications 1 à 11, dans laquelle la carte de circuit imprimé (00) comprend également une paroi latérale conductrice (008), dans laquelle
la paroi latérale conductrice (008) est reliée aux faces d'extrémité de toutes les couches conductrices (001, 002, 004) dans la zone de doigt d'or (00a), dans laquelle la face d'extrémité est parallèle à la direction d'épaisseur de la carte de circuit imprimé (00).

13. Alimentation électrique, dans laquelle l'alimentation électrique comprend des pièces et composants électroniques et la carte de circuit imprimé (00) selon l'une quelconque des revendications 1 à 12, dans laquelle
les pièces et composants électroniques sont soudés sur la zone de soudure (00b) sur la carte de circuit imprimé (00).

14. Système d'alimentation électrique, dans lequel le système d'alimentation électrique comprend l'alimentation électrique selon la revendication 13 et un connecteur femelle, dans lequel dans l'alimentation électrique, un doigt d'or sur une carte de circuit imprimé (00) est inséré dans le connecteur femelle.
